# EUROPEAN PATENT SPECIFICATION

(11) **EP 2 913 860 B1**
(45) Date of publication and mention of the grant of the patent: **16.08.2017**
(21) Application number: 15156843.3
(22) Date of filing: 27.02.2015
(51) Int. Cl.: H01L 51/52

(54) **LIGHTING PANEL**
LEUCHTTAFEL
PANNEAU D'ÉCLAIRAGE

(30) Priority: 28.02.2014 JP 2014039286
(43) Date of publication of application: 02.09.2015
(73) Proprietor: SUMITOMO CHEMICAL CO., LTD., Tokyo 104-8260 (JP)
(72) Inventor: Ishii, Motoko, Tokyo, 151-0051 (JP); Furihata, Masatoshi, Ehime, 792-0015 (JP)
(74) Representative: Vossius & Partner Patentanwälte Rechtsanwälte mbB

(56) References cited:
- WO-A1-2010/116300
- WO-A1-2012/121249
- US-A1- 2004 119 028

## Description

### TECHNICAL FIELD

The present invention relates to a lighting panel using organic electro luminescence (EL) devices.

### BACKGROUND ART

Various lighting panels using organic EL devices that are surface light sources have been developed. Since lighting panels using organic EL devices use surface light sources, such light panels are expected to be applied to indirect lighting, display lighting for making exhibits look better, and aspect lighting for staging indoor and outdoor sights at night, in addition to general lighting. Japanese Patent Application Laid-Open Publication No. 2013-219184 discloses such a lighting panel.

A lighting panel 10 described in Japanese Patent Application Laid-Open Publication No. 2013-219184 includes an organic EL device part 12, a transparent substrate 11 and a sealing plate 13 holding the organic EL device part 12 therebetween, an adhesive member 13c that adheres the transparent substrate 11 and the sealing plate 13 to each other at a peripheral region of the organic EL device part 12 to seal the organic EL device part 12, an extraction electrode 15 connecting the organic EL device part 12 and an external power supply, and transparent acrylic sheets 2, 3 provided on peripheral regions of the organic EL device part 12, the transparent substrate 11 and the sealing plate 13. According to this lighting panel 10, the transparent acrylic sheets 2, 3 provided on the peripheral regions of the organic EL device part 12, the transparent substrate 11 and the sealing plate 13 are transparent, and it is thus possible to provide a lighting panel that is excellent in design.

In addition, in the lighting panel 10 described in Japanese Patent Application Laid-Open Publication No. 2013-219184, screening tapes 2e, 3e are applied to the transparent acrylic sheets 2, 3 so that the extraction electrode 15 and the adhesive member 13c are covered as viewed in the direction of lamination. According to this lighting panel 10, it is possible to conceal the region (the peripheral region of the organic EL device part 12) that impairs the design of the extraction electrode 15, the adhesive member 13c, etc., of the lighting panel with the screening tapes 2e, 3e, and it is thus possible to provide a lighting panel that is excellent in design. The design can further be improved by using metallic-colored glossy tapes as the screening tapes 2e, 3e.

WO 2012/121249, US 2004/119028 and WO 2010/116300 disclose further designs of OLED lighting panels.

### SUMMARY OF THE INVENTION

With the lighting panel described in Japanese Patent Application Laid-Open Publication No. 2013-219184, however, the screening tapes 2e, 3e that conceal the peripheral region of the organic EL device part 12 such as the extraction electrode 15, the adhesive member 13c, etc., of the lighting panel need to be considered as part of the design, which narrows the range of the design of the lighting panel.

The present invention is therefore aimed at providing a lighting panel capable of reducing restrictions on the range of design due to electric wiring and an adhesive member.

A lighting panel according to the present invention is defined in claim 1.

According to this lighting panel, since the portions of the first and second wirings corresponding to the organic EL device and the adhesive member are light transmissive, the entire peripheral region of the organic EL device can be made transparent. It is therefore not necessary to provide a member for concealing the electric wiring and the adhesive member, and it is possible to reduce restrictions on the range of design of the lighting panel due to the electric wiring and the adhesive member.

According to this lighting panel, since light emitted from the organic EL device part is emitted to the outside through the first electrode layer of the organic EL device and the first substrate, the first substrate side of the lighting panel and the second substrate side thereof may be referred to hereinafter as a light emitting face side and a rear face side, respectively.

Note that a light transmissive electrode is used for the electrode on the light-emitting face side of the organic EL device, and it is typical to use wiring having a small electric resistance as wiring for supplying current to the organic EL device. Such wiring having a small electric resistance is normally opaque, but the present inventors have focused on purposely using light transmissive wiring having a relatively high electric resistance as wiring for supplying current to the organic EL device.

Furthermore, according to this lighting panel, since a light reflective electrode layer is used for the second electrode layer of the organic EL device, the rear face of the lighting panel is a specular surface and the light-emitting face thereof is in a light emitting state during light emission. In contrast, while light is turned off, since the second electrode layer is also visually recognized as a specular surface from the light-emitting face side of the lighting panel, both faces are specular surfaces, and it is therefore possible to provide a lighting panel excellent in design.

The lighting EL panel described above is in a form in which first and second auxiliary electrodes provided in an outer peripheral region of the adhesive member on the first substrate, extending along an outer edge (an outer peripheral, an outside, extension) of the adhesive member, connected to the first and second wirings, respectively, and each containing a material having a resistance lower than those of the first and second wirings.

Since light transmissive portions of the first and second wirings have relatively large electric resistances, voltage drop will be large. Since the voltage is lowered, as a result of the voltage drop, by a larger amount at a position farther from the position where power is supplied, luminance lowers correspondingly, and as a result, luminance unevenness tends to occur. In particular, the influence of voltage drop is larger as the light-emitting area of the organic EL device is larger.

According to this structure, however, since the first and second auxiliary electrodes provided in the outer peripheral region of the adhesive member and connected to the first and second wirings, respectively extend along the outer edge of the adhesive member and each contain a material having a resistance lower than those of the first and second wirings, the outer edge of the peripheral region can be at substantially equal voltage, power can be supplied isotropically from the outer edge of the peripheral region, and the luminance unevenness can be reduced.

Furthermore, the lighting EL panel described above may be in a form further including an opaque frame that covers the first and second auxiliary electrodes.

Since the first and second auxiliary electrodes have resistances lower than those of the first and second wirings, the first and second auxiliary electrodes typically have lower light reflectances than those of the first and second wirings, and the auxiliary electrodes thus impair the design of the lighting panel.

According to this structure, the first and second auxiliary electrodes can be concealed by the opaque frame, and it is possible to provide a lighting panel excellent in design.

Furthermore, the lighting panel described above may be in a form in which the lighting panel further includes first and second external lead-out wirings connected to the first and second auxiliary electrode, respectively, and the first and second external lead-out wirings are arranged in the frame and are led from one corner of the frame to outside.

According to this structure, the first and second external lead-out wiring, which impair the design, can be concealed by the frame, and it is possible to provide a lighting panel excellent in design.

Furthermore, according to this structure, the first and second external lead-out wirings can be freely led from any portion of the frame, and it is possible to provide a lighting panel excellent in design.

Furthermore, the lighting panel described above may be in a form in which the lighting panel further includes a light reflection layer provided on the second substrate.

According to this structure, the symmetry of the specular surfaces of the lighting panel, for example, can be easily enhanced by using the specular surface of the light reflection layer in addition to the specular surface of the second electrode layer of the organic EL device. Furthermore, when a drying agent or the like is arranged in a space sealed by the first substrate, the second substrate, and the adhesive member, the drying agent can be concealed by the light reflection layer. Furthermore, when the adhesive member is formed by using an ultraviolet curable adhesive, for example, it is possible to prevent degradation of the organic EL device part (in particular, a light emitting portion) and the drying agent due to ultraviolet irradiation for curing the adhesive member during the production process.

According to the present invention, restrictions on the range of design due to electric wiring and an adhesive member can be reduced.

### BRIEF DESCRIPTION OF THE DRAWINGS

Fig. 1 is a view of a lighting panel according to an embodiment of the present invention on the side of a light-emitting face;
Fig. 2 is a view of the lighting panel according to the embodiment of the present invention on the side of a rear face;
Fig. 3 is a view illustrating electric wiring in detail without illustrating a frame in the lighting panel illustrated in Fig. 1; and
Fig. 4 is a view of a cross-section structure taken along line IV-IV of the lighting panel illustrated in Fig. 1.

### DETAILED DESCRIPTION

Hereinafter, an embodiment of the present invention will be described in detail with reference to the accompanying drawings. Note that the same elements will be designated by the same reference numerals and redundant description will not be repeated in the description of the drawings.

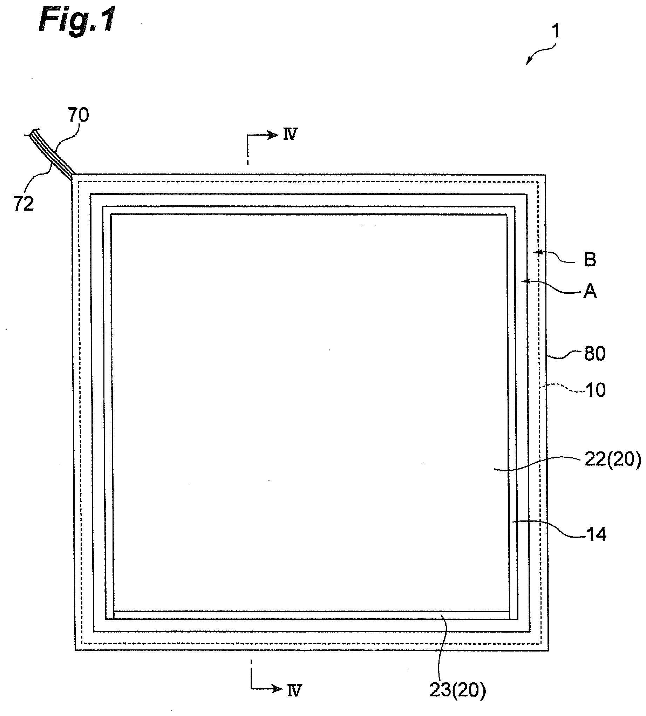

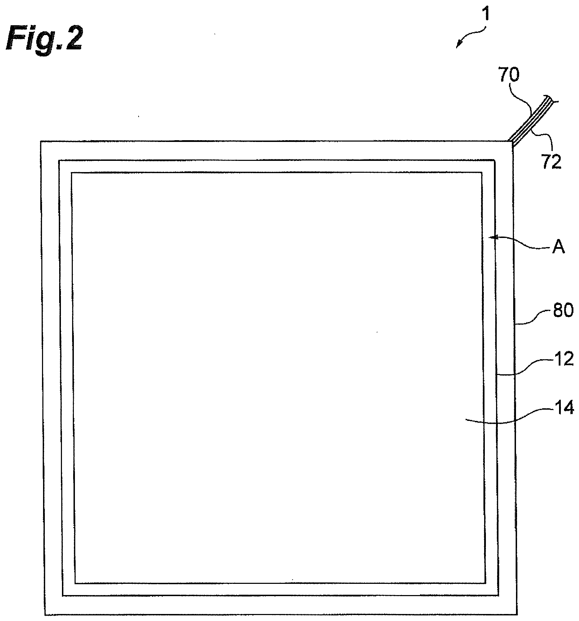

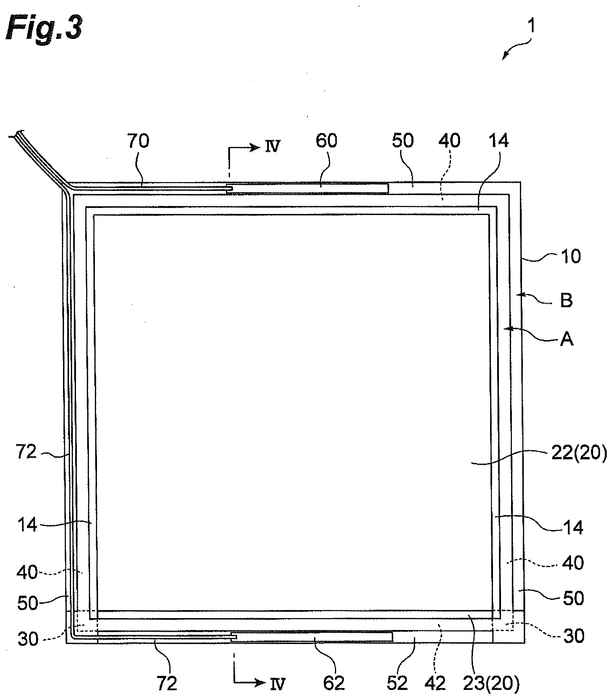

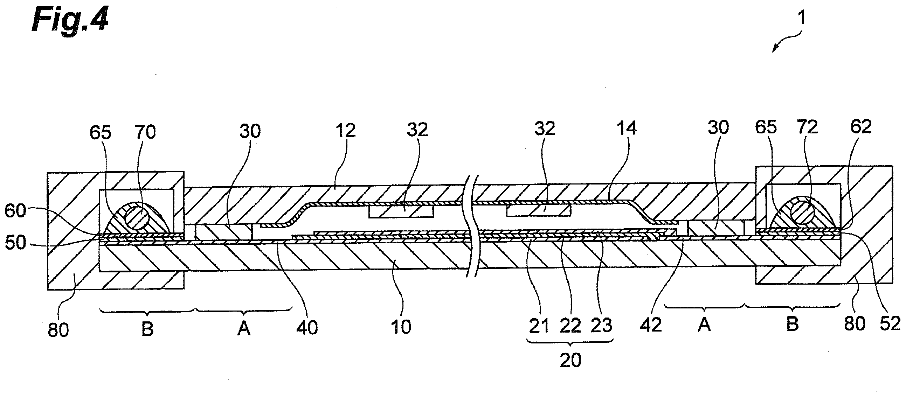

Fig. 1 is a view of a lighting panel according to the embodiment of the present invention on the side of a light-emitting face, and Fig. 2 is a view of the lighting panel according to the embodiment of the present invention on the side of a rear face. In addition, Fig. 3 is a view illustrating electric wiring in detail without illustrating a frame in the lighting panel illustrated in Fig. 1. In addition, Fig. 4 is a view of a cross-section structure taken along line IV-IV of the lighting panel illustrated in Fig. 1.

As illustrated in Figs. 1 to 4, a lighting panel 1 includes a first and second substrates 10, 12, a light reflection layer 14, an organic EL device 20, an adhesive member 30, a drying agent 32, anode wiring (first wiring) 40, cathode wiring (second wiring) 42, anode auxiliary electrode (first auxiliary electrode) 50, cathode auxiliary electrode (second auxiliary electrode) 52, an anode circuit board 60, a cathode circuit board 62, an anode external lead-out wiring (first external lead-out wiring) 70, a cathode external lead-out wiring (second external lead-out wiring) 72, and a frame 80.

The first substrate 10 is arranged on the side of the light-emitting face of the lighting panel 1, and the second substrate 12 is arranged on the side of the rear face of the lighting panel 1. The first and second substrates 10, 12 are constituted by light transmissive substrates. Flexible substrates or rigid substrates are used for the first and second substrates 10, 12, and examples thereof include glass substrates and resin substrates. In the present embodiment, the first and second substrates 10, 12 are constituted by glass substrates that are square flat plates, for example. The organic EL device 20 is arranged between the first substrate 10 and the second substrate 12.

Herein, a given "light transmissive" member refers to a member having a total light transmittance of 30% or more. In addition, a given "light reflective" member refers to a member having a total light reflectance of 70% or more.

The organic EL device 20 has an anode layer (first electrode layer) 21, an organic EL layer 22, and a cathode layer (second electrode layer) 23, and the anode layer 21, the organic EL layer 22, and the cathode layer 23 are laminated in this order on the first substrate 10. The first electrode layer (the anode layer 21 in the present embodiment) is not particularly limited as long as the first electrode layer is a light transmissive electrode, and examples thereof include a conductive metal oxide thin film made of a relatively transparent material such as tin-doped indium oxide (ITO), indium zinc oxide (IZO), and a conductive thin film obtained by thinning a metal such as Au or Ag to such an extent that the thin film is light transmissive. Furthermore, a material having a thickness adjusted so that the material has a lower resistance than the thin film may be arranged in a grid as an auxiliary mesh electrode on the thin film. Furthermore, an insulating film may be formed on the grid-like auxiliary mesh electrode. The insulating film may be an organic matter such as polyimide, or a metal oxide, a silicon oxide, a nitride, or the like. The organic EL layer 22 contains any of various known luminescent materials such as low molecular ones and high molecular ones. The second electrode layer (the cathode layer 23 in the present embodiment) is not particularly limited as long as the second electrode layer is a light reflective electrode, and an electrode made of a conductive material such as a metallic material and having a specular surface formed by a thin film formation technique, for example, is used therefor. The adhesive member 30 is provided along a peripheral edge of a peripheral region A of the organic EL device 20 as viewed on the side of the light-emitting face or on the side of the rear face.

In another embodiment, an organic EL device in which the first electrode layer functions as a cathode layer and the second electrode layer functions as an anode layer may be provided.

The adhesive member 30 is provided around the peripheral region A of the organic EL device 20. Specifically, the adhesive member 30 is arranged around the periphery of the organic EL device 20, and adheres the first substrate 10 and the second substrate 12 to each other. As a result, the organic EL device 20 is sealed and protected from oxygen and moisture in the air. The adhesive member 30 is made of a transparent material such as an ultraviolet curable resin, a thermosetting resin, a delayed ultraviolet curable resin, or a two-pack curable resin made of epoxy resin or other resin, for example. In the present embodiment, the outer edge of the adhesive member 30 is substantially coincident with the outer edge of the peripheral region A. The space between the first substrate 10 and the second substrate 12 may be filled with a light transmissive member different from the adhesive member or the same member as the adhesive member.

A space is provided between the organic EL device 20 and the second substrate 12, in which the drying agent 32 may be provided. As a result, it is possible to keep the organic EL device 20 in a dried state.

Furthermore, the light reflection layer 14 that is light reflective is provided on the second substrate 12 on the side of the organic EL device 20. In the present embodiment, the light reflection layer 14 is provided at a position where the light reflection layer 14 covers the organic EL device 20 as viewed in a direction perpendicular to the second substrate 12 (hereinafter referred to as a plan view), and the outer edge thereof is set between the organic EL device 20 and the adhesive member 30. Specifically, the light reflection layer 14 is arranged at a position where the light reflection layer 14 overlaps with the organic EL device 20 but does not overlap with the adhesive member 30 in plan view. Furthermore, the drying agent 32 described above is arranged at a position where the drying agent 32 overlap with the light reflection layer 14 in plan view. As a result, it is possible to make the drying agent 32 invisible from the rear face. Furthermore, in a case where an ultraviolet curable resin is used as an adhesive, when the rear face is irradiated with ultraviolet light, the ultraviolet light is blocked by the light reflection layer 14, and it is thus possible to prevent degradation of the drying agent 32 during the production process. The light reflection layer 14 is made of a metallic material, for example, and has a specular surface obtained by a thin film formation technique such as a vacuum deposition method, a sputtering method, or a plating method. When the light reflection layer 14 covering the organic EL device 20 is provided, it is not the second electrode layer but the light reflection layer 14 is visually recognized as a specular surface from the rear face of the lighting panel 1, and a region that overlaps with the light reflection layer 14 within the peripheral region A of the organic EL device 20 is visually recognized as a specular surface in plan view.

In another example, the light reflection layer 14 may be provided on the second substrate 12 on the side opposite to the organic EL device 20.

The first and second wirings connected to the organic EL device are also formed on the first substrate 10. The first wiring extends from the first electrode layer to outside of a region surrounded by the adhesive member, and the second wiring extends from the second electrode layer to outside of the region surrounded by the adhesive member. In the present embodiment, the first wiring is referred to as the anode wiring 40 and the second wiring is referred to as the cathode wiring 42. The anode wiring 40 and the cathode wiring 42 are not particularly limited as long as the anode wiring 40 and the cathode wiring 42 are light transmissive and conductive thin films. In the present embodiment, the anode wiring 40 and the cathode wiring 42 are made of the same material as the anode layer 21 of the organic EL device 20, that is, an electrically conductive and transparent material such as ITO. The anode wiring 40 and the cathode wiring 42 are formed integrally with the anode layer 21 by a thin film forming technique, for example, and the anode layer 21 and the anode wiring 40 are separated from the cathode wiring 42 by an etching technique, for example. As a result, the anode wiring 40 and the anode layer 21 are connected, and when the cathode layer 23 is formed, the cathode wiring 42 and the cathode layer 23 are connected. When the organic EL layer 22 is formed, the organic EL layer 22 may lie between the anode layer 21 and the cathode wiring 42. As a result, it is possible to ensure electric insulation between the anode layer 21 and the cathode wiring 42.

The anode wiring 40 extends from three sides of the organic EL device 20 to the peripheral region A of the organic EL device 20 and an outer peripheral region B of the adhesive member. Similarly, the cathode wiring 42 extends from the remaining one side of the organic EL device 20 to the peripheral region A of the organic EL device 20 and the outer peripheral region B of the adhesive member.

In the outer peripheral region B of the adhesive member, the anode auxiliary electrode 50 corresponding to the first auxiliary electrode is provided on the anode wiring 40, and the anode circuit board 60 is provided on the anode auxiliary electrode 50. In addition, in the outer peripheral region B of the adhesive member, the cathode auxiliary electrode 52 corresponding to the second auxiliary electrode is provided on the cathode wiring 42, and the cathode circuit board 62 is provided on the cathode auxiliary electrode 52.

The anode auxiliary electrode 50 and the cathode auxiliary electrode 52 each extend along the outer edge of the adhesive member. In the present embodiment, the anode auxiliary electrode 50 extends in directions along three sides of the organic EL device 20 in a manner corresponding to the anode wiring 40. In addition, the cathode auxiliary electrode 52 extends in a direction along the remaining one side of the organic EL device 20 in a manner corresponding to the cathode wiring 42. The anode auxiliary electrode 50 and the cathode auxiliary electrode 52 contains a material, such as a metallic material, having a lower resistance than the first and second wiring. As described above, in the present embodiment, the outer edge of the adhesive member (that is, the outer edge of the peripheral region A) is surrounded by the anode auxiliary electrode 50 and the cathode auxiliary electrode 52 having low electric resistances. The anode circuit board 60 and the cathode circuit board 62 are flexible printed circuits (FPCs) with anisotropic conductive films (ACFs), for example. The ACFs are arranged between the anode auxiliary electrode 50/the cathode auxiliary electrode 52 and the anode circuit board 60/the cathode circuit board 62, and pressure and heat are applied thereto to adhere and, at the same time, electrically connect the anode auxiliary electrode 50/the cathode auxiliary electrode 52 and the anode circuit board 60/the cathode circuit board 62, respectively.

The anode external lead-out wiring 70 is connected to the anode circuit board 60 by the use of a connecting agent 65 made of solder, for example. The cathode external lead-out wiring 72 is connected to the cathode circuit board 62 by the use of the connecting agent 65 made of solder, for example.

In addition, the frame 80 is provided in the outer peripheral region B of the adhesive member. The frame 80 is made of an opaque resin material, and covers the anode auxiliary electrode 50, the anode circuit board 60, the anode external lead-out wiring 70, the cathode auxiliary electrode 52, the cathode circuit board 62, and the cathode external lead-out wiring 72. The anode external lead-out wiring 70 and the cathode external lead-out wiring 72 are led to the outside from one corner of the frame 80.

According to the lighting panel 1 of the present embodiment, since the anode wiring (first wiring) 40, the cathode wiring (second wiring) 42, and the adhesive member 30 are light transmissive, it is possible to make the entire peripheral region A of the organic EL device 20 transparent. It is therefore not necessary to provide a member for concealing the electric wiring and the adhesive member unlike the lighting panel described in Japanese Patent Application Laid-Open Publication No. 2013-219184, and it is possible to reduce restrictions on the range of design of the lighting panel due to the electric wiring and the adhesive member. Furthermore, it is not necessary to attach transparent acrylic sheets to obtain transparent portions in the peripheral region of the organic EL device unlike the lighting panel described in Japanese Patent Application Laid-Open Publication No. 2013-219184.

When the lighting panel is set in a state hanging alone in a space, for example, an effect that another lighting panel and a background are seen through the peripheral region A of the organic EL device 20 and the lighting panel is recognized as if the lighting panel is floating in the space can also be produced as a result of making the peripheral region A of the organic EL device 20 transparent.

Note that a light transmissive electrode is used for the electrode on the light-emitting face side of the organic EL device, and it is typical to use wiring having a small electric resistance as wiring for supplying current to the organic EL device. Such wiring having a small electric resistance is normally opaque, but the present inventors have focused on purposely using light transmissive wiring having a relatively high electric resistance as wiring for supplying current to the organic EL device.

Furthermore, according to the lighting panel 1 of the present embodiment, since a light reflective electrode layer is used for the cathode layer (second electrode layer) 23 of the organic EL device 20, both faces of the cathode layer 23 can be made to be specular surfaces. Thus, during light emission, the rear face of the lighting panel 1 is a specular surface and the light-emitting face thereof is in a light emitting state. In contrast, while light is turned off, since the cathode layer 23 is also visually recognized as a specular surface from the side of the light-emitting face of the lighting panel 1, both faces (the light-emitting face and the rear face) are specular surfaces. It is therefore possible to provide a lighting panel excellent in design.

Furthermore, although it is difficult to set the shape of the cathode layer 23 independently of the design of the organic EL device or the like since the shape of the cathode layer 23 depends on the shape of the organic EL device, the shape of wiring, and the like, the symmetry, for example, of the specular surfaces of the lighting panel can be easily enhanced by also using the specular surface of the light reflection layer 14.

When a plurality of lighting panels are arranged, an effect that the number of lighting panels appears to be larger than the actual number of light panels can also be produced by the structure in which both faces of the lighting panel 1 are specular surfaces.

Note that, since the anode wiring (first wiring) 40 and the cathode wiring (second wiring) 42 that are light transmissive have relatively high electric resistances, voltage drop will be large. Since the voltage is lowered, as a result of the voltage drop, by a larger amount at a position farther from the position where power is supplied, luminance lowers correspondingly, and as a result, luminance unevenness tends to occur. In particular, the influence of voltage drop is larger as the light-emitting area of the organic EL device is larger.

In this regard, according to the lighting panel 1 of the present embodiment, since the anode auxiliary electrode (first auxiliary electrode) 50 and the cathode auxiliary electrode (second auxiliary electrode) 52 provided in the outer peripheral region B of the adhesive member 30 and connected to the anode wiring 40 and the cathode wiring 42, respectively, extend along the outer edge of the adhesive member 30 and contain materials having lower resistances than the anode wiring 40 and the cathode wiring 42, the outer edge of the peripheral region can be at substantially equal voltage, power can be supplied isotropically from the outer edge of the peripheral region, and the luminance unevenness can be reduced.

Furthermore, according to the lighting panel 1 of the present embodiment, the adhesiveness of solder for connecting the anode external lead-out wiring can be enhanced by placing the anode circuit board 60 and the cathode circuit board 62 between the anode external lead-out wiring (first external lead-out wiring) 70/the cathode external lead-out wiring (second external lead-out wiring) 72 and the anode auxiliary electrode (first auxiliary electrode)50/the cathode auxiliary electrode (second auxiliary electrode) 52, respectively.

Furthermore, according to the lighting panel 1 of the present embodiment, the anode auxiliary electrode (first auxiliary electrode) 50, the anode circuit board 60, the anode external lead-out wiring (first external lead-out wiring) 70, the cathode auxiliary electrode (second auxiliary electrode) 52, the cathode circuit board 62, and the cathode external lead-out wiring (second external lead-out wiring) 72, which impair the design, can be concealed by the opaque frame 80 that covers these components, and it is possible to provide a lighting panel excellent in design.

Furthermore, according to the lighting panel 1 of the present embodiment, since the anode external lead-out wiring (first external lead-out wiring) 70 and the cathode external lead-out wiring (second external lead-out wiring) 72 are led to the outside from one corner of the frame 80, it is possible to provide a lighting panel excellent in design.

Note that the present invention is not limited to the embodiment described above, but various modifications can be applied thereto. For example, while the entire anode wiring (first wiring) 40 and the entire cathode wiring (second wiring) 42 are constituted by light transmissive members in the present embodiment, only at least a portion of the anode wiring 40 corresponding to the peripheral region A and at least a portion of the cathode wiring 42 corresponding to the peripheral region A need to be constituted by the light transmissive members.

Furthermore, while the anode layer (first electrode layer) 21, the anode wiring 40, and the cathode wiring (second wiring) 42 of the organic EL device 20 are formed of ITO in the present embodiment, mesh-like thin metallic wires may be formed on a light transmissive and conductive thin film such as an ITO thin film as the anode layer 21, the anode wiring 40, and the cathode wiring 42 to such an extent that the light transmissivity is not impaired.

Furthermore, in the present embodiment, the drying agent 32 and the light reflection layer 14 need not necessarily be provided. In this case, a structure in which both faces of the lighting panel are specular surfaces can be realized by the cathode layer (second electrode layer) 23 of the organic EL device 20.

Furthermore, although an example of a square lighting panel is presented in the present embodiment, the features of the present invention can also be applied to various forms such as other quadrangular shapes such as a rectangle, polygonal shapes, and circular shapes.

Furthermore, although a form of an organic EL device including a light-emitting layer and a pair of electrodes is presented as an example in the present embodiment, the organic EL device may be in other forms in which various known functional layers such as an electrode transport layer, a hole transport layer, an electron injection layer, and a hole injection layer are also included.

### REFERENCE SIGNS LIST

1 lighting panel
10 first substrate
12 second substrate
14 light reflection layer
20 organic EL device
21 anode layer (first electrode layer)
22 organic EL layer
23 cathode layer (second electrode layer)
30 adhesive member
32 drying agent
40 anode wiring (first wiring)
42 cathode wiring (second wiring)
50 anode auxiliary electrode (first auxiliary electrode)
52 cathode auxiliary electrode (second auxiliary electrode)
60 anode circuit board
62 cathode circuit board
65 connecting agent
70 anode external lead-out wiring (first external lead-out wiring)
72 cathode external lead-out wiring (second external lead-out wiring)
80 frame
A peripheral region of organic EL device
B outer peripheral region of adhesive member

## Claims

1. A lighting panel comprising:
a first substrate (10) that is light transmissive;
a second substrate (12) that is light transmissive and provided in a state opposed to the first substrate (10);
an organic EL device (20) provided between the first and second substrates (10, 12);
an adhesive member (30) provided between the first and second substrates (10, 12) and surrounding a peripheral region (A) of the organic EL device (20) to adhere the first and second substrates (10, 12) to each other;
first and second wirings (40, 42) connected to the organic EL device (20), and
first and second auxiliary electrodes (50, 52) provided in an outer peripheral region (B) of the adhesive member (30) on the first substrate (10), extending along an outer edge of the adhesive member (30), connected to the first and second wirings (40, 42), respectively, and each containing a material having a resistance lower than those of the first and second wirings (40, 42)
wherein
the organic EL device (20) includes a first electrode layer (21) that is light transmissive, an organic EL layer (22) containing a luminescent material, and a second electrode layer (23) that is light reflective, laminated in this order on the first substrate (10),
the first wiring (40) extends from the first electrode layer (21) to outside of a region surrounded by the adhesive member (30),
the second wiring (42) extends from the second electrode layer (23) to outside of the region surrounded by the adhesive member (30),
portions of the first and second wirings (40, 42) corresponding to the peripheral region (A) and the adhesive member (30) are light transmissive, **characterized in that** the peripheral region (A) is transparent as viewed from the side of the first substrate (10),
the outer edge of the adhesive member (30) is surrounded by the first auxiliary electrode (50) and the second auxiliary electrode (52).

2. The lighting panel according to claim 1, **characterized in that** the lighting panel further comprises an opaque frame (80) covering the first and second auxiliary electrodes (50, 52).

3. The lighting panel according to claim 2, further comprising first and second external lead-out wirings (70, 72) connected to the first and second auxiliary electrodes (50, 52), respectively, **characterized in that**
the first and second external lead-out wirings (70, 72) are arranged in the frame (80) and led from one corner of the frame (80) to outside.

4. The lighting panel according to any one of claims 1 to 3, **characterized in that** the lighting panel further comprises a light reflection layer (14) provided on the second substrate (12).

## Patentansprüche

1. Lichtpaneel mit:
einem ersten Substrat (10), das lichtdurchlässig ist;
einem zweiten Substrat (12), das lichtdurchlässig ist und in einem Zustand gegenüberliegend dem ersten Substrat (10) angeordnet ist;
einer zwischen dem ersten und dem zweiten Substrat (10, 12) angeordneten organischen EL-Vorrichtung (20);
einem Klebeelement (30), das zwischen dem ersten und dem zweiten Substrat (10, 12) angeordnet ist und einen Umfangsbereich (A) der organischen EL-Vorrichtung (20) umgibt, zum Verkleben des ersten und des zweiten Substrats (10, 12) miteinander;
einer ersten und einer zweiten Verdrahtung (40, 42), die mit der organischen EL-Vorrichtung (20) verbunden sind; und
einer ersten und einer zweiten Hilfselektrode (50, 52), die in einem Außenumfangsbereich (B) des Klebeelements (30) auf dem ersten Substrat (10) angeordnet sind, sich entlang eines Außenrandes des Klebeelements (30) erstrecken, mit der ersten und der zweiten Verdrahtung (40, 42) verbunden sind und jeweils ein Material mit einem Widerstandswert enthalten, der niedriger ist als derjenige der ersten und der zweiten Verdrahtung (40, 42), wobei
die organische EL-Vorrichtung (20) eine erste Elektrodenschicht (21), die lichtdurchlässig ist, eine organische EL-Schicht (22), die ein lumineszierendes Material enthält, und eine zweite Elektrodenschicht (23) aufweist, die lichtreflektierend ist, wobei diese Schichten in dieser Folge auf das erste Substrat (10) laminiert sind,
die erste Verdrahtung (40) sich von der ersten Elektrodenschicht (21) zur Außenseite eines Bereichs erstreckt, der vom Klebeelement (30) umgeben ist,
Abschnitte der ersten und der zweiten Verdrahtung (40, 42), die dem Umfangsbereich (A) und dem Klebeelement (30) entsprechen, lichtdurchlässig sind;
**dadurch gekennzeichnet, dass**
der Umfangsbereich (A) betrachtet von der Seite des ersten Substrats (10) transparent ist;
der Außenrand des Klebeelements (30) von der ersten Hilfselektrode (50) und der zweiten Hilfselektrode (52) umgeben ist.

2. Lichtpaneel nach Anspruch 1, **dadurch gekennzeichnet, dass** das Lichtpaneel ferner einen opaken Rahmen (80) aufweist, der die erste und die zweite Hilfselektrode (50, 52) abdeckt.

3. Lichtpaneel nach Anspruch 2, ferner mit einem ersten und einem zweiten herausgeführten externen Kabel (70, 72), die mit der ersten und der zweiten Hilfselektrode (50, 52) verbunden sind,
**dadurch gekennzeichnet, dass**
das erste und das zweite herausgeführte externe Kabel (70, 72) im Rahmen (80) angeordnet und von einer Ecke des Rahmens (80) nach außen geführt sind.

4. Lichtpaneel nach einem der Ansprüche 1 bis 3, **dadurch gekennzeichnet, dass** das Lichtpaneel ferner eine auf dem zweiten Substrat (12) ausgebildete lichtreflektierende Schicht (14) aufweist.

## Revendications

1. Panneau d'éclairage comprenant :
un premier substrat (10) qui transmet la lumière ;
un second substrat (12) qui transmet la lumière et est prévu de manière opposée au premier substrat (10) ;
un dispositif EL organique (20) prévu entre le premier et le second substrats (10, 12) ;
un élément adhésif (30) prévu entre le premier et le second substrats (10, 12) et entourant une zone périphérique (A) du dispositif EL organique (20) afin d'adhérer au premier et au second substrat (10, 12) l'un à l'autre ;
un premier et un second câblage (40, 42) reliés au dispositif EL organique (20), et
une première et une seconde électrode auxiliaire (50, 52) prévues dans une zone périphérique externe (B) de l'élément adhésif (30) sur le premier substrat (10), en s'étendant le long d'un bord externe de l'élément adhésif (30), reliées au premier et au second câblage (40, 42), respectivement, et contenant chacune un matériau qui présente une résistance inférieure à celle du premier et du second câblage (40, 42),
dans lequel
le dispositif EL organique (20) comprend une première couche d'électrode (21) qui transmet la lumière, une couche EL organique (22) contenant un matériau luminescent, et une seconde couche d'électrode (23) qui réfléchit la lumière, stratifiées dans cet ordre sur le premier substrat (10),
le premier câblage (40) s'étend entre la première couche d'électrode (21) et l'extérieur d'une zone entourée par l'élément adhésif (30),
le second câblage (42) s'étend entre la seconde couche d'électrode (23) et l'extérieur de la zone entourée par l'élément adhésif (30),
des parties du premier et du second câblage (40, 42) correspondant à la zone périphérique (A) et à l'élément adhésif (30) transmettent la lumière, **caractérisé en ce que**
la zone périphérique (A) est transparente lorsqu'on la regarde depuis le côté du premier substrat (10),
le bord externe de l'élément adhésif (30) est entouré par la première électrode auxiliaire (50) et la seconde électrode auxiliaire (52).

2. Panneau d'éclairage selon la revendication 1, **caractérisé en ce que** le panneau d'éclairage comprend en outre un cadre opaque (80) qui recouvre la première et la seconde électrode auxiliaire (50, 52).

3. Panneau d'éclairage selon la revendication 2, comprenant en outre un premier et un second câblage de sortie externes (70, 72) reliés à la première et la seconde électrode auxiliaire (50, 52), respectivement, **caractérisé en ce que**
le premier et le second câblage de sortie externes (70, 72) sont prévus dans le cadre (80) et vont d'un angle du cadre (80) vers l'extérieur.

4. Panneau d'éclairage selon l'une quelconque des revendications 1 à 3, **caractérisé en ce que** le panneau d'éclairage comprend en outre une couche de réflexion de la lumière (14) prévue sur le second substrat (12).
